# EUROPEAN PATENT SPECIFICATION

(11) **EP 0 497 801 B1**
(45) Date of publication and mention of the grant of the patent: **19.07.1995**
(21) Application number: 90915315.7
(22) Date of filing: 19.10.1990
(51) Int. Cl.: H03L 7/08, H03C 3/09

(54) **A PHASE LOCKED LOOP FOR PRODUCING A REFERENCE CARRIER FOR A COHERENT DETECTOR**
PHASENREGELSCHLEIFE ZUR HERSTELLUNG EINES REFERENZTRÄGERS FÜR EINEN KOHÄRENTEN DETEKTOR
BOUCLE A VERROUILLAGE DE PHASE SERVANT A PRODUIRE UNE PORTEUSE DE REFERENCE POUR UN DETECTEUR COHERENT

(30) Priority: 25.10.1989 FI 895068
(43) Date of publication of application: 12.08.1992
(73) Proprietor: NOKIA TELECOMMUNICATIONS OY, 02600 Espoo (FI)
(72) Inventor: MÄKINEN, Jarmo, SF-02600 Espoo (FI)
(74) Representative: Bohnenberger, Johannes, Dr.
(86) International application number: FI9000248
(87) International publication number: WO9107016

(56) References cited:
- EP-A- 0 044 155
- GB-A- 2 188 201
- US-A- 4 074 209
- PATENT ABSTRACTS OF JAPAN, Vol. 12, No 261, E636, Abstract of JP 63- 46815, publ 1988-02-27, TOSHIBA CORP.

## Description

The present invention relates to a phase locked loop for producing a reference carrier for a coherent detector, comprising a first phase detecting means which compares the estimated carrier frequency of an incoming signal and the frequency of a local reference carrier oscillator and produces a control signal proportional to the phase difference between said two frequencies to adjust the frequency of the reference carrier oscillator.

Traditionally, coherent detectors operate at relatively low fixed intermediate frequencies, whereby a voltage-controlled freely oscillating oscillator controlled by a circuit detecting the phase difference between the reference carrier and the estimated carrier of the received signal is used to produce the reference carrier.

However, the frequency accuracy of a freely oscillating oscillator is not sufficient if the coherent detector has to operate at a relatively high carrier frequency and the frequency of the oscillator has to be variable within a wide range and sufficiently accurately to ensure that the desired signal to be received is found. Instead, a reference frequency locked to a quartz crystal has to be used. The required frequency accuracy and easy variability of the frequency is obtained by phase locking and by using frequency dividers. So the required device is a kind of frequency synthesizer.

A problem with such a frequency synthesizer is that the circuit which detects the phase of the estimated carrier of a received signal should be able to fine-adjust the frequency of the reference carrier oscillator to compensate for the frequency jitter and drift present in the received signal and in the oscillators of the detectors. It should be possible to fine-adjust the reference carrier oscillator at a rate which is not dependent on the bandwidth of the phase locked loop contained in the frequency synthesizer. In other words, the output frequency of the frequency synthesizer should be controllable by a control signal the bandwidth of which may range from a so-called zero frequency (no changes in the control signal) to a frequency considerably higher than the frequency determined by the tracking rate of the phase locked loop (very rapid changes in the control signal).

A conventional phase-locked-loop system is known, for example, from EP-A-0 044 155.

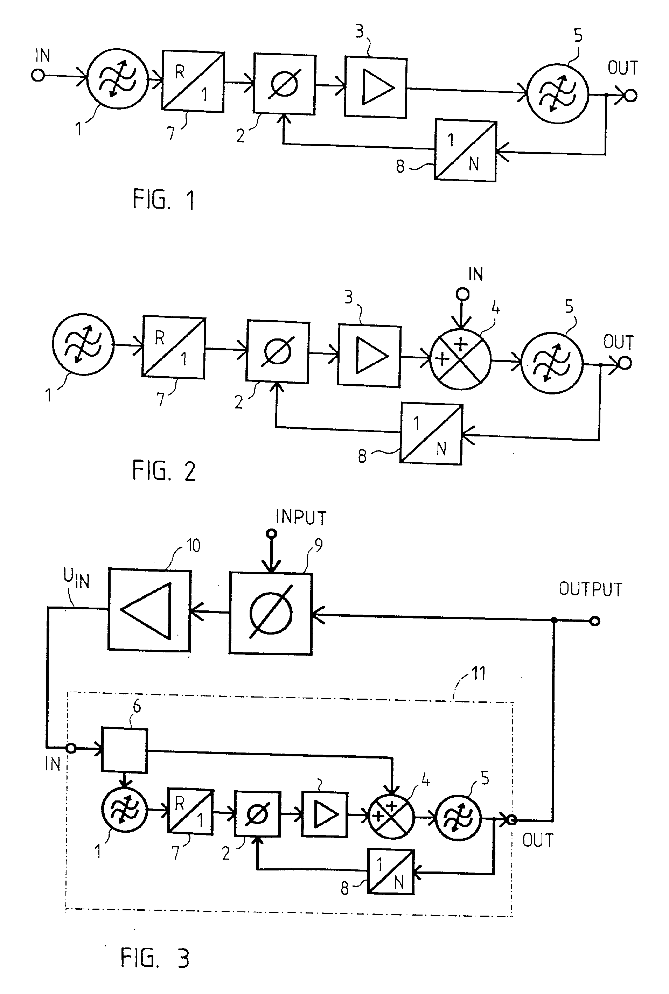

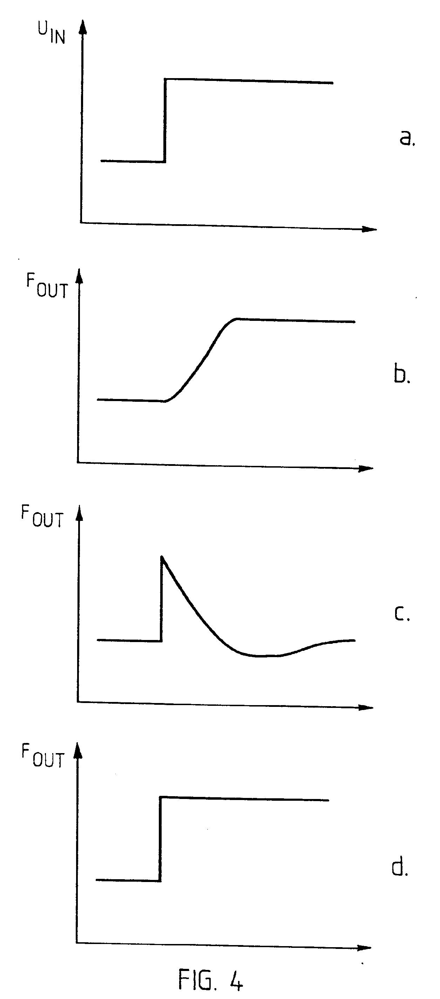

If the reference carrier oscillator is formed, for instance, by the prior art frequency synthesizer arrangement of Figure 1, the rate of the fine adjustment is not sufficient. In Figure 1, the voltage-controlled loop oscillator 5 of the phase locked loop is controlled through a loop amplifier 3 by a phase detector 2 which detects the phase difference between the output frequencies of a reference oscillator 1 and the loop oscillator 5, the output frequencies being applied to the detector through divider circuits 7 and 8, correspondingly. The reference oscillator is provided with a frequency adjusting input IN for adjusting the frequency of the output signal OUT of the phase locked loop. When a step change of the type shown in Figure 4a occurs in the control signal IN, the reference frequency changes correspondingly, so that the phase detector 2 detects the phase difference and controls the loop oscillator 5 in such a way that the phase difference is eliminated. The frequency adjustment of the output signal OUT caused by the phase locked loop is, however, rather slow, wherefore the output frequency changes in a ramp-like manner as a result of a step change occurring in the control signal, as shown in Figure 4b. In other words, the frequency adjustment of the phase locked loop is not able to follow rapid changes occurring in the control signal. At its maximum, the bandwidth of the frequency adjustment is typically no more than about one fifth of the bandwidth of the phase locked loop.

If the reference carrier oscillator is formed by the frequency synthesizer arrangement of Figure 2, static fine adjustment is not possible. The connection of Figure 2 differs from that described above in that the frequency adjusting signal does not control the reference oscillator 1 but it is summed together with the output signal of the loop amplifier 3 in a summer 4 the output signal of which controls the loop oscillator 5. The step change occurring in the frequency adjusting signal thereby immediately appears in the output frequency of the synthesizer without the delay caused by the phase locked loop; on the other hand, the phase locked loop corrects the output frequency back to its original value at a rate dependent on its delay, as shown in Figure 4c. In this solution, the frequency (rate of change) of the control signal may have a value equal to or greater than a frequency determined by the tracking rate of the loop. The arrangement of Figure 2, however, is not able to maintain the output frequency at the new value determined by the control signal, in addition to which it is not operative, due to the high-pass filter effect caused by the phase locked loop in the frequency adjustment, when the frequency of the control signal is lower than the frequency determined by the tracking rate of the phase locked loop, so that the long-term average (static state) of the output frequency of the synthesizer cannot be adjusted.

Neither one of these prior art arrangements is applicable in cases where the bandwidth of the control signal should range from the zero frequency to a frequency exceeding the frequency determined by the tracking rate of the phase locked loop.

The object of the present invention is to provide a phase locked loop which enables the production of a reference carrier for a coherent detector operating at a high signal frequency which has to be easily variable within a wide frequency range.

This is achieved by means of a phase locked loop of the type described in the beginning, which according to the invention is characterized in that the reference carrier oscillator comprises a reference oscillator; a loop oscillator the output frequency of which is equal to said reference carrier frequency; a second phase detecting means having inputs to which the output of the reference oscillator and the output of the loop oscillator are connected either directly or through frequency dividers; and frequency adjusting means which in response to the control signal produced by the first phase detecting means adjust the frequency of the reference carrier oscillator by simultaneously adjusting both the reference oscillator and the loop oscillator in such a way that the frequencies at the inputs of the second phase detecting means change to a substantially equal degree and in the same direction.

In the invention, the circuit which detects the phase difference between the received carrier and the reference carrier fine-adjusts the reference oscillator by adjusting simultaneously and to an equal degree the loop oscillator and the reference oscillator belonging to the reference carrier oscillator. Further in the invention, the bandwidth of the frequency adjusting signal of the reference oscillator is not restricted but may range from the zero frequency to a frequency considerably higher than the upper extreme frequency determined by the tracking rate of the phase locked loop, that is, in theory, infinite. Therefore the output frequency of the reference carrier oscillator is able to follow the frequency of the received signal sufficiently rapidly while maintaining the new frequency value determined by the changed control signal.

The invention will now be described in greater detail by means of embodiments with reference to the attached drawings, wherein
Figure 1 is a block diagram of a prior art frequency synthesizer;
Figure 2 is a block diagram of another prior art frequency synthesizer;
Figure 3 is a block diagram of a phase locked loop of the invention for producing a reference carrier for a coherent detector; and
Figure 4 illustrates responses of the output frequencies of the reference carrier oscillators of the circuits of Figures 1, 2 and 3 to a step change occurring in the control signal.

The object of the invention is to produce a reference carrier for coherent detection. The invention is typically applicable in connection with a coherent detector of QAM signals (Quadrature Amplitude Modulation), whereby the signal to be received does not contain the carrier frequency used in the transmission but only the sidebands resulted from the modulation. Therefore the frequency and phase of the carrier used in the transmission have to be estimated from the received signal, using a phase estimator operating on the Costas principle, for instance. The invention is also applicable in coherent FM (Frequency Modulation) or AM (Amplitude Modulation) detectors, whereby the received signal also contains the carrier frequency. As used in this text, the term *estimated carrier frequency* refers generally to both of the above-described signal types.

Figure 3 shows one phase locked loop of the invention, comprising a phase detector 9 having an input to which a received radio-frequency signal is applied, the phase and frequency of the carrier used in the transmission being estimated from the signal. The output voltage of the phase detecting circuit 9 is applied to a frequency adjusting input IN in a loop oscillator 11 contained in the phase locked loop, which loop oscillator acts as a reference carrier oscillator of the invention to produce of a reference carrier for a coherent detector. The output of the reference carrier oscillator 11 is connected to the output of the phase locked loop and to another input in the phase detecting circuit 9. The phase detecting circuit 9 corrects the value of the adjusting voltage applied to the oscillator 11 in such a way that no phase difference occurs between the reference carrier produced by the oscillator 11 and a carrier estimated from a signal received at a signal input INPUT, whereby the output frequency or reference carrier of the phase locked loop is locked to the estimated carrier frequency.

In Figure 3, the reference carrier oscillator 11 of the invention contains a reference frequency oscillator 1 which is preferably a voltage-controlled crystal oscillator 1 and the output signal of which is connected through a frequency divider circuit 7 to one input in a phase detector 2. To another input in the phase detector 2, an output signal OUT from the reference carrier oscillator 11 is connected through another frequency divider circuit 8. The phase detector 2 detects the phase difference between the signals at its inputs and generates an output voltage proportional to the phase difference. This output voltage is amplified by a loop amplifier 3 and applied to an input in a summer 4. The summer 4 sums the amplified output voltage of the phase detecting circuit 2 to a frequency adjusting voltage at its other input, thus generating at its output a sum voltage which is applied to a control input in a voltage-controlled loop oscillator (VCO) 5, whereby the sum voltage determines the frequency of the output signal of the loop oscillator 5, i.e., the above-mentioned reference carrier frequency.

The reference carrier oscillator 11 shown in Figure 3 further comprises a frequency adjusting block 6 having a control input and two adjustment outputs one of which is connected to the control input of the reference frequency oscillator 1 and the other to the other input in the summer 4. The frequency adjusting block 6 generates, at its both adjusting outputs, a frequency adjusting voltage in response to an adjusting voltage Uᵢₙ occurring at its input IN. The ratio of the magnitudes of the adjusting voltages occurring at the adjusting outputs is selected so that a change in the adjusting voltage Uᵢₙ causes equal frequency changes in the same direction in the signals at the inputs of the phase detector 2. Thereby the phase detector 2 does not observe any phase difference between the signals during the adjustment, by virtue of which the properties of the phase locked loop will not affect the operation of the frequency adjustment. In practice, the ratio of the adjusting voltage applied to the reference oscillator 1 to the adjusting voltage applied to the summer 4 is R/S1:N/S5, where R is the divisor of the division circuit 7, N is the divisor of the division circuit 8, S1 is the slope of adjustment of the oscillator 1, and S5 is the slope of adjustment of the oscillator 5.

The reference carrier oscillator 11 of Figure 3 operates in the following way. When the adjusting voltage Uᵢₙ occurring at the input IN of the frequency adjusting block 6 varies as shown in Figure 4a, the frequency adjusting block 6 applies a frequency adjusting voltage to the loop oscillator 5 through the summer 4. This frequency adjusting voltage contains a corresponding change and it causes a corresponding step change to occur in the output frequency Fₒᵤₜ of the oscillator and accordingly in the output frequency of the entire oscillator 11 without the delay caused by the phase locked loop, as shown in Figure 4d. At the same time the frequency adjusting block 6 applies a second adjusting voltage to the reference frequency oscillator 1, which adjusting voltage adjusts the reference frequency oscillator 1 in such a way that a change in the frequency of the signal applied to the phase detecting circuit 2 through the divider circuit 7 is equal to a change in the frequency of another signal applied to the phase detecting circuit 2 through the divider circuit 8. Since the reference frequency is also reset, the phase detecting circuit 2 does not observe any phase difference between the signals and does not tend to compensate for the change which has occurred in the output frequency of the loop oscillator 5 but maintains the new output frequency, as shown in Figure 4d.

The practical realization of the structural blocks shown in Figure 3 is obvious to one skilled in the art. For the sake of clarity, the example deals with analog signals only, but the invention is equally realizable when using digital phase detectors, frequency dividers and frequency converters without affecting the basic idea of the invention.

At its simplest, the frequency adjusting block 6 contains suitable attenuators or amplifiers, by means of which the frequency adjusting voltage Uᵢₙ is divided into two portions. The block 6 may also contain phase inverting circuits and circuits intended for shaping the frequency response of the frequency adjustment. On the other hand, the block 6 can possibly be omitted, in which case it has to be ensured that the oscillators 1 and 5 will nevertheless be adjusted according to the invention.

The loop amplifier 3 may contain integrators and filters and in certain cases it can be omitted as well.

The attached drawings and the description related to them are only intended to illustrate the present invention. In its details, the phase locked loop may vary within the scope of the attached claims.

## Claims

1. A phase locked loop for producing a reference carrier for a coherent detector, comprising
a first phase detecting means (9) which compares the estimated carrier frequency of an incoming signal and the frequency of a local reference carrier oscillator (11) and produces a control signal proportional to the phase difference between said two frequencies to adjust the frequency of the reference carrier oscillator (11);
**characterized** in that the reference carrier oscillator (11) comprises
a reference oscillator (1);
a loop oscillator (5) the output frequency of which is equal to said reference carrier frequency;
a second phase detecting means (2) having inputs to which the output of the reference oscillator (1) and the output of the loop oscillator (5) are connected either directly or through frequency dividers (7, 8); and
frequency adjusting means (6) which in response to the control signal produced by the first phase detecting means (9) adjust the frequency of the reference carrier oscillator (11) by simultaneously adjusting both the reference oscillator (1) and the loop oscillator (5) in such a way that the frequencies at the inputs of the second phase detecting means change to a substantially equal degree and in the same direction.

2. A phase locked loop according to claim 1, **characterized** in that the frequency adjusting means (6) produce two control signals one of which is applied to the reference oscillator (1) and the other to a summing means (4) to be summed with the output signal of the second phase detecting means (2) to produce a sum signal controlling the loop oscillator (5).

3. A phase locked loop according to claim 1 or 2, **characterized** in that the output frequency of the reference oscillator (1) and the output frequency of the loop oscillator (5) are applied directly to the second phase detecting means (2), the control signals being dimensioned so as to cause an equal change in the output frequency of both oscillators (1, 5).

4. A phase locked loop according to claim 1 or 2, **characterized** in that the output frequency of the reference oscillator (1) is divided with a term (R) and the output frequency of the loop oscillator (5) is divided with a term (N) before being applied to the second phase detecting means (2), where N and R are integer constants, the control signals being dimensioned so that the ratio of the change of the output frequency of the reference oscillator (1) to the change of the output frequency of the loop oscillator (5) is R/N.

## Patentansprüche

1. PLL-Schaltkreis zum Erzeugen eines Referenzträgers für einen Kohärenzdetektor, wobei der Schaltkreis aufweist:
eine erste Phasendetektiereinrichtung (9), die die geschätzte Trägerfrequenz eines ankommenden Signals und die Frequenz eines lokalen Referenzträgeroszillators (11) miteinander vergleicht und ein Steuersignal erzeugt, das zu der Phasendifferenz zwischen den beiden Frequenzen proportional ist, um die Frequenz des Referenzträgeroszillators (11) abzugleichen;
**dadurch gekennzeichnet**, daß der Referenzträgeroszillator (11) aufweist:
einen Referenzoszillator (1);
einen Schleifenoszillator (5), dessen Ausgangsfrequenz gleich der Referenzträgerfrequenz ist;
eine zweite Phasendetektiereinrichtung (2), die Eingänge hat, mit denen der Ausgang des Referenzoszillators (1) und der Ausgang des Schleifenoszillators (5) entweder direkt oder über Frequenzteiler (7, 8) verbunden sind; und
eine Frequenzabgleicheinrichtung (6), die aufgrund des von der ersten Phasendetektiereinrichtung (9) erzeugten Steuersignals die Frequenz des Referenzträgeroszillators (11) abgleicht durch gleichzeitiges Abgleichen sowohl des Referenzoszillators (1) als auch des Schleifenoszillators (5) auf solche Weise, daß die Frequenzen an den Eingängen der zweiten Phasendetektiereinrichtung sich in einem im wesentlichen gleichen Maß und in der gleichen Richtung ändern.

2. PLL-Schaltkreis nach Anspruch 1,
**dadurch gekennzeichnet,** daß die Frequenzabgleicheinrichtung (6) zwei Steuersignale erzeugt, von denen eines dem Referenzoszillator (1) und das andere einer Summiereinrichtung (4) zugeführt wird, um mit dem Ausgangssignal der zweiten Phasendetektiereinrichtung (2) summiert zu werden und ein Summensignal zu erzeugen, das den Schleifenoszillator (5) steuert.

3. PLL-Schaltkreis nach Anspruch 1 oder 2,
**dadurch gekennzeichnet**, daß die Ausgangsfrequenz des Referenzoszillators (1) und die Ausgangsfrequenz des Schleifenoszillators (5) der zweiten Phasendetektiereinrichtung (2) direkt zugeführt werden, wobei die Steuersignale dimensioniert sind, um eine gleiche Änderung der Ausgangsfrequenz beider Oszillatoren (1, 5) zu bewirken.

4. PLL-Schaltkreis nach Anspruch 1 oder 2,
**dadurch gekennzeichnet,** daß die Ausgangsfrequenz des Referenzoszillators (1) mit einem Term (R) dividiert wird und die Ausgangsfrequenz des Schleifenoszillators (5) mit einem Term (N) dividiert wird, bevor sie der zweiten Phasendetektiereinrichtung (2) zugeführt werden, wobei N und R ganzzahlige Konstanten sind, wobei die Steuersignale so dimensioniert sind, daß das Verhältnis der Änderung der Ausgangsfrequenz des Referenzoszillators (1) zu der Änderung der Ausgangsfrequenz des Schleifenoszillators (5) R/N ist.

## Revendications

1. Boucle à verrouillage de phase pour la production d'une porteuse de référence pour un détecteur cohérent, comprenant
- un premier moyen de détection de phase (9) qui compare la fréquence de la porteuse estimée d'un signal d'entrée avec la fréquence d'un oscillateur (11) engendrant la porteuse de référence locale, et produit un signal de commande qui est proportionnel à la différence de phase entre lesdites deux fréquences en vue d'ajuster la fréquence de l'oscillateur de la porteuse de référence (11),
caractérisée en ce que l'oscillateur (11) de la porteuse de référence comprend
un oscillateur de référence (1),
un oscillateur de boucle (5) dont la fréquence de sortie est égale à la fréquence de la porteuse de référence,
un deuxième moyen de détection de phase (2) aux entrées duquel sont reliées la sortie de l'oscillateur de référence (1) et la sortie de l'oscillateur de boucle (5), soit directement, soit par des diviseurs de fréquence (7, 8) ; et
des moyens d'ajustement de fréquence (6) qui, en réponse au signal de commande produit par le premier moyen de détection de phase (9), ajustent la fréquence de l'oscillateur (11) de la porteuse de référence en ajustant simultanément aussi bien l'oscillateur de référence (1) que l'oscillateur de boucle (5), de manière à ce que les fréquences aux entrées du deuxième moyen de détection de phase soient modifiées sensiblement dans la même mesure et dans le même sens.

2. Boucle à verrouillage de phase selon la revendication 1,
caractérisée en ce que les moyens d'ajustement de fréquence (6) produisent deux signaux de commande dont l'un est appliqué à l'oscillateur de référence (1) et l'autre, à un moyen d'addition (4) pour être additionné au signal de sortie du deuxième moyen de détection de phase (2) pour produire un signal global qui commande l'oscillateur de boucle (5).

3. Boucle à verrouillage de phase selon la revendication 1 ou 2,
caractérisée en ce que la fréquence de sortie de l'oscillateur de référence (1) et la fréquence de sortie de l'oscillateur de boucle (5) sont directement appliquées au deuxième moyen de détection de phase (2), les signaux de commande étant dimensionnés pour provoquer une modification identique de la fréquence de sortie des deux oscillateurs (1, 5).

4. Boucle à verrouillage de phase selon la revendication 1 ou 2,
caractérisée en ce que la fréquence de sortie de l'oscillateur de référence (1) est divisée par un facteur (R) et la fréquence de sortie de l'oscillateur de boucle (5) est divisée par un facteur (N), avant d'être appliquées au deuxième moyen de détection de phase (2), N et R étant des constantes entières, et les signaux de commande étant dimensionnés de manière à ce que le rapport entre la modification de la fréquence de sortie de l'oscillateur de référence (1) et la modification de la fréquence de sortie de l'oscillateur de boucle (5) soit R/N.
